# EUROPEAN PATENT SPECIFICATION

(11) **EP 2 966 575 B1**
(45) Date of publication and mention of the grant of the patent: **01.08.2018**
(21) Application number: 15172174.3
(22) Date of filing: 09.06.2009
(51) Int. Cl.: G06F 13/40

(54) **VEHICLE COMPUTING MODULE**
FAHRZEUGRECHENMODUL
MODULE DE CALCUL DE VÉHICULE

(43) Date of publication of application: 13.01.2016
(62) Divisional of application: 09007617.5
(73) Proprietor: Harman Becker Automotive Systems GmbH, 76307 Karlsbad (DE)
(72) Inventor: KRAFT, Günther, 76133 Karlsruhe (DE); ERFORTH, Thomas, 76185 Karlsruhe (DE)
(74) Representative: Bertsch, Florian Oliver

(56) References cited:
- EP-A- 1 615 141
- US-A- 5 983 297
- US-A- 6 003 100
- "PCI Local Bus Specification Revision 2.2 -- Chapter 2: Signal Definition", PCI LOCAL BUS SPECIFICATION, XX, XX, 18 December 1998 (1998-12-18), XP002300650,

## Description

### Field of the Invention

The present invention relates to a vehicle computing module and to a vehicle computing system comprising such a vehicle computing module. The invention further relates to the use of such a vehicle computing module in a vehicle computing system.

### Background

In modern vehicles, a plurality of functions is often computer-controlled. As an example, an infotainment system of the vehicle may comprise a computer platform making a plurality of information and entertainment functions available to the user. Such functions may comprise the playback of audio or video files, e.g. from a CD or a DVD, the running of navigation software for providing guidance to the driver of the vehicle or computing a speech recognition. With the development of new processors and new system architectures in recent years the processing power of systems was and will be dramatically increased within relatively short time spans. Significant increases in performance are generally achieved within one to three years, and media or software tailored to these systems can often not be played back or executed on older systems.

Vehicle computer systems are often generally configured for a particular type of vehicle, and are fixedly mounted inside the vehicle. As the life span of a vehicle ranges up to 15 years and even beyond, the computing system of the vehicle will be outdated after only a small fraction of the vehicle's lifetime. A new computer system that is tailored to the specific vehicle will generally not be available once the model line is discontinued. Vehicle users are thus tied to their obsolete computer systems and may not be capable of benefiting from recent developments and improvements in computing systems.

The technology cycles of modern CPUs are usually in the range of 1 - 1.5 years. Compared to that the standard development cycle for an automotive head unit from the first idea to series production is in the range of 3 years. This bears the risk that the new head unit starts it lifecycle with an already outdated processing unit.

A further problem are the specific requirements that must be met in an automotive environment. A common computer system that may be upgradeable by e.g. exchanging a processor can generally not be employed in an automotive environment. First of all, the computing system needs to be customized for the particular type of vehicle. The geometry of the system needs to be adapted to the installation space available, and the interfaces need to be adapted to the particular application, e.g. if vehicle-specific information is to be exchanged. Second, a computing system for a vehicle needs to meet very stringent operation requirements. The computing system needs to ensure a failure-safe operation in a wide range of environmental conditions, such as a wide temperature and humidity range. Due to the limited installation space, heat removal is another important issue which prevents the use of conventional computing systems in a vehicle. Connectors and mounting elements further have to meet the requirements regarding resistance to vibrations.

The US patent 6,003,100 discloses a CPU card having a central processing unit mounted on a substrate and a socket connector for connecting the CPU card to a system board. The interface to the system board uses signal definitions according to the PCI local bus specifications.

The US patent 5,983,297 discloses a processor module including a circuit board containing a processor, a voltage regulator and a primary bridge. The system memory is comprised on a separate circuit board to which the processor module is connected by a socket interface providing a PCI bus and a memory bus.

The European patent application EP 1 615 141 A2 relates to a computing architecture for a mobile multi-media navigation system used in a land-based vehicle. The components including a central processor and a memory are fixedly mounted in a computing unit.

### Summary of the Invention

Accordingly, there is a need for an improved vehicle computing system that obviates at least some of the drawbacks mentioned above.

This need is met by the features of the independent claims. The dependent claims describe preferred embodiments of the invention.

According to a first aspect of the invention, a vehicle computing module adapted to be connected to a mainboard of a vehicle computing system is provided. The vehicle computing module comprises a circuit board with conduction paths, computing components mounted to the circuit board and including at least a central processing unit (CPU) and a main memory, an edge connector provided at an edge of the circuit board and adapted to connect the circuit board to an edge connector socket of the mainboard, and a plurality of interfaces provided by said edge connector for interfacing the computing module. The vehicle computing module is adapted to be operated in a vehicle as a main computing unit of said vehicle computing system, and to perform the processing of data for the vehicle computing system, the data being received by the vehicle computing module via the interfaces. Said interfaces comprise a Debug and Boot Port (DBP) interface and the vehicle computing module is configured to receive boot mechanisms from a controller of the mainboard. The processing of data may be performed by the vehicle computing module independently, i.e. the vehicle computing module may correspond to a fully functional computer. As a main computing unit, the module may perform most of the data processing for the vehicle computing system. It may for example perform at least 50% or even more than 75% of the processing, or even all of the processing for the vehicle computing system. The vehicle computing system may thus not comprise an additional central processing unit on its mainboard. The vehicle computing system may also be provided with several vehicle computing modules sharing the processing load. With the module performing the main processing for the vehicle computing system, the remaining parts of the computing system may only perform auxiliary processing functions, which can be adapted to the particular automotive environment.

As the module employs an edge connector, it can be easily mounted to the mainboard of the vehicle computing system. Accordingly, the vehicle computing module can substitute an outdated vehicle computing module, thereby upgrading the computing system of the vehicle. The computing system, which can be adapted to the particular type of vehicle in which it is mounted, does not need to be exchanged. The processing power of the vehicle-adapted computing system can thus be kept up to date over the life span of the vehicle and even during the development time. As the vehicle computing module is adapted to be operated in a vehicle, it can meet the stringent requirements set for automotive components.

According to an embodiment of the invention, the interfaces comprise at least one of a Peripheral Component Interconnect Express (PCIe) interface, a Universal Serial Bus (USB) interface, a Serial Advanced Technology Attachment (SATA) interface, a Secure Digital Input/Output (SDIO) interface, a Low Voltage Differential Signalling (LVDS), and a Power Supply Control interface. It may also comprise a Universal Asynchronous Receiver/Transmitter (UART) interface. The vehicle computing module may also comprise a combination or all of these interfaces. The vehicle computing module can thus have the capability of receiving data in a number of different ways and can operate as a fully functional computer. The specification of these interface can enable the use of the same type of vehicle computing module with different vehicle-adapted computing systems. Further, these interfaces provide a fast and reliable exchange of data and ensure a compatibility with a great variety of peripheral components.

The DBP interface may be capable of supporting CPUs of different generations and different vendors without changing the pin assignment of the edge connector. By means of the DBP interface the processor operation may be checked and operating software may be adjusted. It can provide an advantageous tool for debug, software upgrade and production test. The Debug and Boot Port interface provided by the edge connector may be directly connected to a corresponding interface provided by the central processing unit. The DBP interface of the processing unit may thus directly be accessed via the edge connector. As an example, the DBP interface may use at least four pins of the edge connector. In other embodiments, the DBP interface may use two or three pins, depending on the processing unit employed. The computing system may lead the DBP interface through to a maintenance port accessible by a technician, so that maintenance can be performed when the vehicle computing system and the vehicle computing module are installed inside the vehicle.

The computing components and the circuit board including the conduction paths may be adapted to meet predetermined specifications for an operation inside a vehicle. Thus, a degradation of the computing module, e.g. a corrosion of the conduction paths, can be prevented during operation inside the vehicle. The predetermined specifications may for example include specifications regarding temperature and/or humidity.

The circuit board may comprise one or more ball grid areas, wherein the circuit board may be configured such that in areas of the circuit board different from the ball grid areas, trace to pad, via to pad and pad to pad distances are larger than 200µm. Further, the circuit board may comprise a solder mask having a string width of at least 100µm.

The automotive specifications regarding the damp heat can be met. By such a layout, corrosion of or unwanted connections between conducting paths, e.g. due to condensation, can be prevented.

The computing components and the circuit board may be adapted to enable the operation of the computing module within a temperature range of -40 to 70°C, preferably between -40 and 85°C (ambient temperature module). In order to achieve such an operation, the heat production of the computing components may need to be restricted.

The module may comprise a module cover, and at least some of the computing components may be coupled to the module cover via a thermal bridge, so that the module cover acts as a heat spreader for the computing components coupled thereto. The module cover can be adapted to be connected to a housing or a mechanical frame of the computing system. It may also be a mechanical part of the computing system. Some of the heat produced by the computing components may thus be removed. As a thermal bridge, a heat conducting pad or a heat conducting paste may be used. As an example, components having a heat dissipation of at least 0.5 W and up to 3-6 W may be provided with a thermal bridge and coupled to the module cover.

Computing components which have a thermal power loss above a predetermined threshold value may be provided with a heat bridge adapted to be coupled to a housing of the vehicle computing system. By coupling to the housing the heat removal can be even more efficient for these components. The predetermined threshold value may for example lie within a range between 3 W and 6 W.

Other means for removing the produced heat are also conceivable. The CPU may for example be provided with an integrated heat spreader (IHS) housing. Such a IHS can provide a large surface for heat removal.

Each of the computing components may be adapted to have a thermal power loss of less than 7 W in operation. The generation of heat by the vehicle computing module can thus be limited.

The edge connector may comprise connections for at least two different operating voltages, with a first of the operating voltages lying in a range between 2.5 and 3.5 V, and a second of the operating voltages lying within a range between 4.5 and 5.5 V. As an example, 3.3 V and 5 V may be provided. Further voltages may be generated from these operating voltages on the vehicle computing module, such as core voltages in the range between 0.1 - 2.5V

The computing components may further comprise a northbridge and a southbridge or a combined north/ southbridge, a clock generator, and local voltage converters. A clock generator and a voltage converter can be combined in a single chip solution. They may further comprise a flash memory. The northbridge may also be integrated within the central processing unit. Further components may of course also be provided, such as a graphics chip, and the like, or functional units may be combined, e.g. in one chip, such as an application-specific integrated circuit (ASIC) or a system controller.

The circuit board may be a high density interconnect (HDI) board or a Through Hole Technology (THT) board with at least six, preferably eight to ten layers. The vehicle computing module may have a size of inbetween 80x80 mm and 120 x120 mm, with the height depending on the computing components and the heat removal components provided on the board. The edge connector may have 200-250 pins.

Furthermore, the interfaces may comprise General Purpose Input/Output (GPIO) interfaces which may be adapted to the particular type of vehicle computing module or vehicle computing system. Different functions may be assigned to these interfaces, e.g. in dependence on whether the vehicle computing module is used in a more recent or in an older vehicle computing system, or what type of processor or chipset the vehicle computing module is equipped with.

According to a further aspect of the invention a vehicle computing system comprising a mainboard having interfaces towards components of the vehicle and an edge connector socket adapted to receive an edge connector, and further comprising a vehicle computing module as mentioned above and adapted to be connected to said mainboard by means of the edge connector is provided. With such a vehicle computing system advantages similar to the ones outlined above may be achieved.

According to an embodiment, the vehicle computing system is a vehicle-specific system adapted to a particular type of vehicle to which it is to be mounted, and the vehicle computing module is a standardized vehicle computing module adapted to be used with a plurality of different vehicle computing systems adapted to different types of vehicles. Such a vehicle computing system has the advantage of being optimized for a particular type of vehicle while still being producible at relatively low costs by using a standardized computing module. Further, the computing module of the vehicle computing system can be easily upgraded. In particular, the form factor, the connector(s) and/or the interfaces of the vehicle computing system may be adapted to a specific type of vehicle.

The mainboard may further comprise a field-programmable gate array (FPGA), an application-specific integrated circuit (ASIC) or a microcontroller for controlling the start-up of and/or the communication with the vehicle computing module. The FPGA or ASIC may for example adapt and configure the GPIO interfaces towards the vehicle computing module.

The edge connector socket may be formed so that the mainboard and the circuit board of the vehicle computing module have a distance in a range between 2 and 9 mm, preferably between 6 and 8 mm. That way the vehicle computing module can be equipped on both sides with computing components.

The vehicle computing system may be selected from the group comprising a vehicle infotainment system, a vehicle multi-media system, a vehicle navigation system, a vehicle control system, and an integrated vehicle computing system combining two or more of the systems mentioned above . The interfaces of the mainboard towards the vehicle may comprise at least one of the Controller Area Network (CAN) interface, a Local Interconnect Network (LIN) interface, and a Media Oriented Systems Transport (MOST) interface. The mainboard can be configured to transport data received on one of these interfaces to the vehicle computing module for processing.

A further aspect of the invention relates to the use of one of the above-mentioned vehicle computing modules in a vehicle for performing processing functions for a computing system of the vehicle. As mentioned above, the use of such a vehicle computing module in a vehicle is beneficial, as it allows the upgrading of the vehicle computing system. Further, only one type of vehicle computing module needs to be provided for a range of computing systems adapted to different types of vehicles.

It is to be understood that the features mentioned above and those yet to be explained below can be used not only in the respective combinations indicated, but also in other combinations or in isolation, without leaving the scope of the present invention.

### Brief Description of the Drawings

The foregoing and other features and advantages of the invention will become further apparent from the following detailed description of illustrative embodiments when read in conjunction with the accompanying drawings. In the drawings like reference numerals refer to like elements.
Fig. 1 is a schematic block diagram illustrating a vehicle computing module according to an embodiment of the present invention.
Fig. 2 is a schematic block diagram illustrating a vehicle computing system according to an embodiment of the present invention.
Fig. 3 is a schematic sectional side view of a vehicle computing system according to an embodiment of the present invention.

### Detailed Description

It is to be understood that the following description of embodiments is given only for the purpose of illustration and is not to be taken in a limiting sense. The drawings are to be regarded as being schematic representations only, and elements in the drawings are not necessarily to scale with each other. Rather, the representation of the various elements is chose such that their function and general purpose become apparent to a person skilled in the art. The partitioning of embodiments in functional blocks or units shown in the drawings is not to be construed as indicating that these units necessarily are implemented as physically separate units, but functional block or units shown or described may be implemented as separate units, circuits, chips or circuit elements, but one or more functional blocks or units may as well be implemented in a common circuit, chip, circuit element or unit.

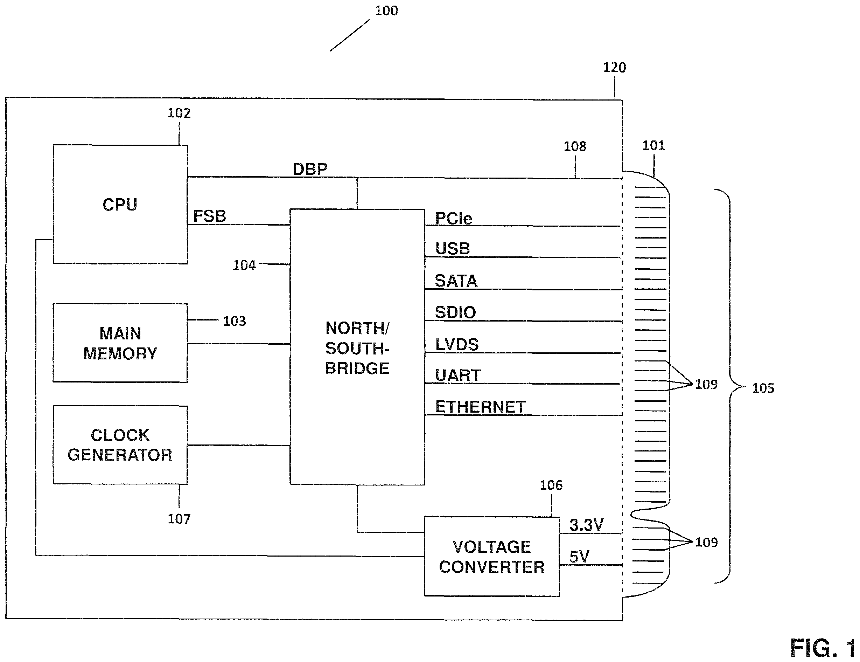

Fig. 1 shows a vehicle computing module 100 according to an embodiment of the present invention. Module 100 comprises an edge connector 101 provided on an edge of the module. Edge connector 101 comprises a plurality of pins 109 and is adapted to fit into an edge connector socket mounted to a mainboard of a vehicle computing system. The edge connector comprises 200-250 pins, e.g. 230 pins, which contact corresponding conducting elements when the module is inserted into the edge connector socket. The pins can have a center to center distance or pitch of between 0.4 and 0.6 mm, e.g. 0.5 mm. This will avoid unwanted contact between neighboring pins. The requirements regarding the humidity in which the vehicle computing module can be operated can thus be met.

Edge connector 101 provides a plurality of interfaces 105 towards the vehicle computing module 100. The interfaces 105 comprise a Peripheral Component Interconnect Express (PCIe) interface, a Universal Serial Bus (USB) interface, a Serial Advanced Technology Attachment (SATA) interface, a Secure Digital Input/Output (SDIO) interface, a Low Voltage Differential Signalling (LVDS) interface, a Universal Asynchronous Receiver/Transmitter (UART) interface, an Ethernet interface and two interfaces (3.3 V and 5 V) for supplying the module with power. It should be clear that some of these interfaces are optional, such as the UART and the Ethernet interface, and that further interfaces may be provided, such as a display I2C interface, a video in interface, a SM bus interface, a SPI interface, plural General Purpose Input/Output (GPIO) interfaces, a power supply control interface and the like. The following table 1 shows an example interface configuration of a vehicle computing module according to an embodiment of the invention, with the number of the respective interfaces that are provided being indicated in column 2.

| **Interface** | **Up to** | **Comment** |
|---|---|---|
| PCIexpress, 1 lane | 4 | |
| USB 2.0 | 5 | 4 Host, 1 Function |
| Ethernet | 1 | 10/100/1000 Mbit Base-T MDI (PHY) in terface |
| SATA | 2 | |
| SDIO | 3 | 2 x 4 bit, 1 x 8 bit |
| LVDS | 2 | |
| Display I2C | 2 | |
| Video In | 1 | BT.656 with 8 bit data |
| DBP | 1 | Generic Debug and Boot Port |
| SMBus | 1 | |
| SPI | 1 | |
| UART | 1 | |
| GPIO | 16 | Up to 12 pins may be for FPGA programming |
| Power Supply Control | 5 | RESET IN/OUT#, WAKE#, SUS_STAT#, POWER_ON |
| Others | 1 | OVER_TEMP |

One or more pins of the edge connector may be assigned to each interface. For example, five to ten pins may be assigned to the Debug and Boot Port (DBP) interface 108. The GPIO interfaces may for example be used for adapting the module to the particular central processing unit (CPU) 102 used on module 100. By providing the interfaces mentioned above, the interface configuration can be kept even if modules comprising new processor generations or processors/chipsets from different vendors are produced, thereby ensuring the compatibility of the vehicle computing module 100 with vehicle computing systems installed in vehicles. The module installed in a vehicle can thus be upgraded with new module versions over the lifetime of the vehicle.

Vehicle computing module 100 may further comprise a northbridge generally providing a memory controller and a southbridge generally providing input/output controllers for the remaining interfaces. The southbridge may for example already comprise a USB controller. In the embodiment of Fig. 1 module 100 comprises a combined north/southbridge 104. North/southbridge 104 may for example be provided in the form of a one chip solution, e.g. a system controller, which may also comprise graphics processing functionality. Other configurations are of course also possible, the northbridge may for example be integrated within CPU 102. Other types of input/output (I/O) hubs may also be employed. North/southbridge 104 interfaces the main memory 103, which can be a random access memory (RAM). Clock generator 107 interfaces north/southbridge 104 may also interface CPU 102. It should be clear that several separate clock generators may be provided for generating clocking signals for the different components of vehicle computing module 100. CPU 102 can be a single core or multi core processor.

Module 100 further comprises voltage converter 106 which generates core voltages from the voltages supplied via the edge connector, e.g. for operating CPU 102. It should be clear that the voltage converter 106 may comprise a number of physically separate units distributed on module 100. Module 100 is provided with a 5 V and 3.3. V powerrail system for an optimized load distribution. The use of a single powerrail system is also possible. Optionally, a 3.3 V stand-by powerrail may also be made available. Voltage converter 106 may generate a range of core voltages, such as 1, 1.5, 1.8,..., and 2.5 V.

The debug/boot port (DBP) interface 108 is a generic representation of the dedicated debug and boot port interface of the chipset located on module 100. The DBP interface 108 of module 100 can be connected to a debug edge connector of a mainboard of the vehicle computing system towards which the module 100 is attached. The connection can occur with an unmodified pin assignment independent of the CPU used on the module. Via the debug edge connector on the mainboard and edge connector 101 of module 100 the DBP of CPU 102 can directly be accessed. The adaptation to the CPU-specific interface can be done with off-board tools, which can be connected to the debug edge connector. As an example, for an Intel® chipset the LPC bus may be assigned to the DBP while for a Renesas chipset the same signals as for a HUDI interface can be used. With the DBP concept it is possible to provide a standardized interface pin assignment while supporting different processing units/chipsets with different debug interfaces.

Software debugging and firmware updates can be easily performed via the DBP interface even if the module 100 is mounted to the vehicle computing system. As the vehicle computing system is generally mounted within a small and confined space, it is advantageous to directly lead out the debug and boot port of the chipset of the module via the edge connector 101 and the debug edge connector of the mainboard, so that it can be accessed from outside without having to unmount the computing system.

Naturally, vehicle computing module 100 may comprise further components not shown in Fig. 1. As an example, it may comprise an additional graphics chip for performing graphics processing, a flash memory or a NAND flash memory for storing data, and the like. A flash or NAND flash memory may also be placed on the mainboard and accessed via edge connector 101. Other storage media, such as hard disk drives and the like may also be located on or connected to the mainboard of the computing system and accessed via the edge connector 101, e.g. using the SATA interface.

Due to the limited space available for mounting the vehicle computing system, the dimensions of module 100 are also restricted. Length and width of the module may lie within a range of 80x80 mm to 120x120 mm, it may for example have a size of 80x110 mm. Module 100 may comprise a multilayer circuit board, which can be produced using the high density interconnect (HDI) or Through Hole technology. It may have more than six, preferably between eight to ten, layers. With the HDI circuit board a reduction in size can be achieved, and the requirements regarding the signal integrity for the fast bus systems can be easier met.

Vehicle computing module 100 is specifically adapted for the use in an automotive environment. In particular, it is adapted to operate in a temperature range between -40°C to 85°C at different degrees of humidity. In order to achieve the operation in such high temperatures, the components of module 100 are adapted to generate a power loss of less than 7 W each. The module 100 is configured to have a total power loss of less than 30 W. Preferably, it is configured to have a power loss of less than 20W or even less than 15W. The components of module 100 having a power loss above 0.5 to 2 W are coupled to a module housing or module cover (indirect heat bridge) or directly to the housing of the vehicle computing system (direct heat bridge). The components can be provided with materials having a high thermal conductivity, such as heat conducting pads or head conducting paste and the like. Components having a particularly high thermal power loss, such as CPU 102, may be provided with an integrated heat spreader (IHS) housing to provide a large surface for heat exchange. The direct coupling or the additional heat spreaders may for example be employed for components having a thermal power loss of more than 3 to 5 Ws.

Module 100 is further adapted to operate in damp heat conditions. In such conditions, condensation can occur resulting in a malfunction of the module, e.g. due to unwanted connections between circuit traces and the like. In order to enable the operation in damp heat conditions, , the circuit board is configured such that in non-ball grid areas, trace to pad, via to pad and pad to pad distances are larger than 200µm. The ball grid area (BGA) is for example the area underneath one or more computing components that are mounted to the circuit board using a ball grid, e.g. underneath components such as the processing unit, the main memory, a controller, an ASIC or other chips or integrated circuits (ICs). Pads are generally used to establish an electrical contact to components, while vias or microvias are used to provide electrical connections between traces on different layers of the circuit board, e.g. when using a multilayer board.

Some type of varnish or resist, such as solder resist, may be used for covering the conducting paths on the outer layers of the circuit board. The circuit board comprises a solder mask having a string width of at least 100µm.

Leakage currents and other types of malfunctions can thus be prevented in damp heat conditions. It should be clear that the solid lines shown in the figures connecting the computing components are only schematic representations of connections and do not represent actual traces. CPU 102 and north/southbridge 104 may for example have a plurality of traces connecting them, which may run on different layers of board 120.

By using the layout described above and the outlined arrangements for removing the heat produced by the components, the stringent requirements for operating the vehicle computing module 100 inside a vehicle can be met. It should be clear that the computing components themselves, such as CPU 102 and north/ southbridge 104, are adapted to be operable in the temperature range indicated above.

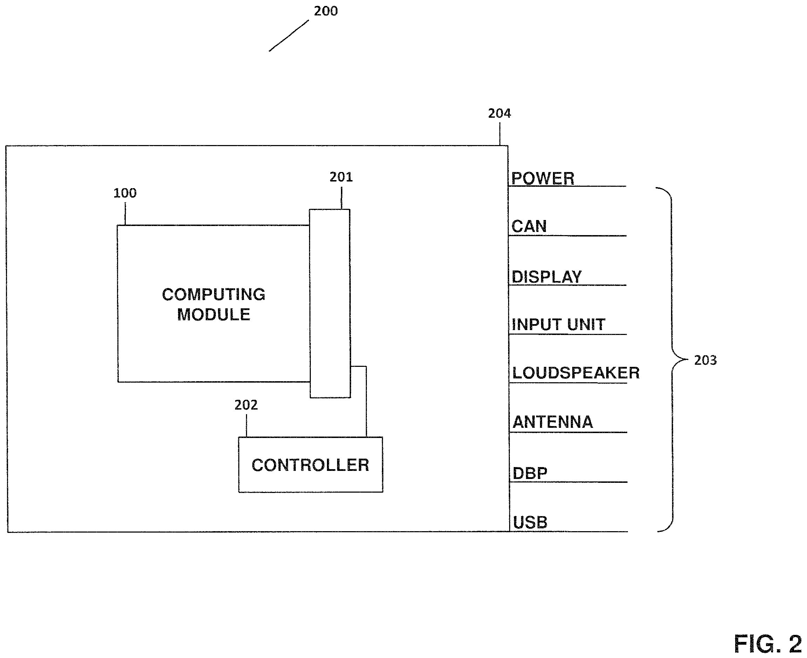

Fig. 2 shows a schematic representation of a vehicle computing system 200. System 200 may be an infotainment system, a vehicle navigation system, a vehicle multimedia system, or a vehicle control system, or a combination thereof. It can for example be mounted to a single DIN or a double DIN-sized slot of the vehicle. Vehicle computing system 200 comprises an edge connector socket 201 via which computing module 100 is connected to mainboard 204. Depending on the configuration, the socket can be provided in different heights, e.g. between 5 and 8 mm. The socket or edge card connector 201 comprises contacts corresponding to the pins on the edge connector of vehicle computing module 100. The circuit board 120 of computing module 100 may be configured with a thickness to match the edge connector socket used, e.g. with a thickness of 1.2 ± 0.1 mm. The connection between module 100 and edge connector socket 201 has to meet the requirements for use in an automotive environment, e.g. regarding vibrations. This can be achieved by selecting or adapting the socket 201 so as to meet these requirements, e.g. by ensuring high enough contact forces for contacting the pins of the edge connector 101. Further, computing module 100 can be mechanically fixed to the mainboard 204 of computing system 200, e.g. using bolts or the like. A firm, detachable connection can thus be achieved, enabling a straightforward removal or exchange of vehicle computing module 100.

Mainboard 204 is adapted to the particular type of vehicle in which computing system 200 is deployed. It may for example provide a range of vehicle-specific interfaces, such as a CAN, a LIN or a MOST interface, depending on the particular application. The interfaces 203 of the mainboard 204 towards other components of the vehicle may comprise an interface towards a vehicle-mounted display, a vehicle-mounted input unit, or vehicle-mounted loudspeakers, as well as interfaces towards an antenna, such as a GPS, Bluetooth® or WLAN antenna, or a radio antenna, or an interface towards a USB connector mounted to the dashboard of the vehicle or a face plate of the computing system. Consequently, mainboard 204 may comprise application-specific analog audio and video circuits, such as digital-to-analog or analog-to-digital converters, and the like. Some interfaces of computing module 100 may be directly connected to the corresponding interface of the computer system 200, such as the USB interface, or may be connected via a controller or the like. Mainboard 204 further comprises a DBP interface in the form of a mainboard debug edge connector, which is directly connected to the corresponding DBP interface of module 100. An adaptor may then be connected to the mainboard debug edge connector to enable access to the particular type of CPU used on module 100.

While vehicle computing system 200 is adapted to the specific type of vehicle in terms of mechanical form factor, connectors and interfaces, the vehicle computing module 100 is a standardized module which can be connected to a range of different types of systems 200. In order to provide such an interoperability, the interface between the module 100 and the mainboard 204 is standardized, i.e. the interfaces of the module 100 are provided by predetermined pins of the edge connector. When adapting system 200 to the vehicle, the interfaces to the module 100 do not need to be changed, and the standardized module can be employed. When new generations of processors and chipsets are available, interface converters can be provided on vehicle computing module 100, so as to ensure the compatibility with older vehicle computing systems. The DBP concept provides the required flexibility in the standardized interface to support several generations of processing units from different vendors. Vehicle computing system 200 has not only the advantage that vehicle computing module 100 can be produced at relatively low costs, as it can be employed in a wide range of computing systems and thus be produced in large numbers, but also that the computing system 200 is easily upgradable to the latest processors and chipsets available.

System 200 further comprises the controller 202, which may be a FPGA, a ASIC or a microcontroller. Controller 202 may be used for adapting the general purpose input/output interfaces to the particular type of module 100 used. In an example configuration 16 GPIO ports are provided, with 13 ports being reserved for an optional FPGA programming, e.g. in a slave parallel mode. A programming in a slave serial mode is also possible. By programming the controller 202 via the GPIO interfaces, a certain adaptation of the computing system 200 to the module 100 employed becomes possible. Controller 202 may further perform controlling functions for the interfaces between the computing module 100 and the mainboard 204. The controller 202 comprises start-up or boot mechanisms for the computing system 200. It should be clear that controller 202 may comprise plural ASICs, FPGAs, microcontrollers, or combinations thereof, provided with different of the functionalities mentioned above.

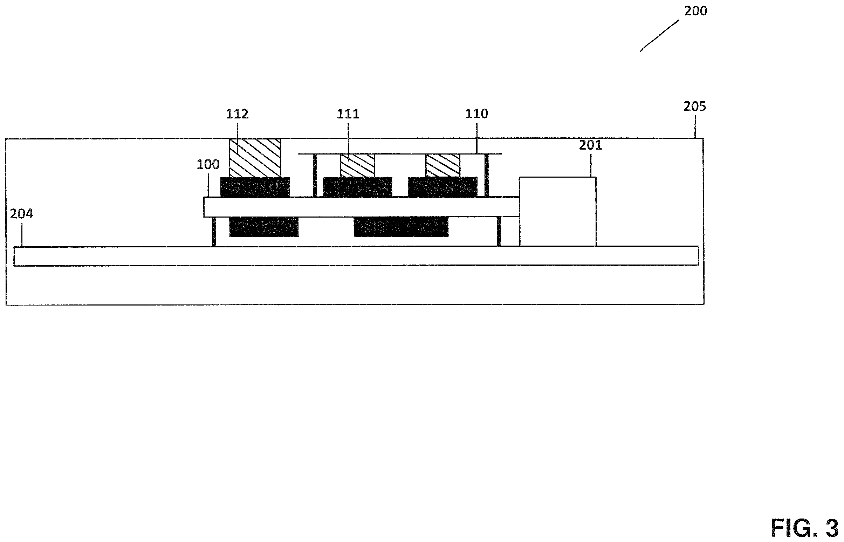

Fig. 3 is a sectional side view of the vehicle computing system 200. The drawing illustrates the distance between the mainboard 204 and the module 100 when the module is inserted into the edge connector socket 201. Preferably, a distance is chosen such that module 100 can be equipped with computing components on both sides. As an example, the distance between circuit board 120 of computing module 100 and main board 204 may be adjusted to inbetween 6 to 8 mm. Computing components are indicated with black rectangles in Fig. 3. As indicated, module 100 can be mechanically attached to mainboard 204 by pins, studs or bolts or the like. Module 100 further comprises a cover 110. For removing heat from the computing components, some components are thermally coupled to the cover 100 by means of a heat conducting pad 111 or the like. Other computing components are directly coupled to the housing 205 of the computing system 200, again by using a heat conducting pad or a heat spreader 112. Cover 110 may of course also be thermally coupled to housing 205. An effective removal of the heat generated by the thermal power loss of the computing components can thus be achieved.

In summary, the present invention provides a vehicle-adapted computing system with a standardized vehicle computing module that can be employed in a range of differently adapted systems. By using such a standardized computing module, cost savings in the development and production of vehicle-adapted computing systems can be achieved. As the vehicle computing system is easily upgradable by exchanging the module, the user can benefit from the most recent improvements in processing power during the lifetime of the vehicle.

## Claims

1. Vehicle computing module (100) adapted to be connected to a mainboard (204) of a vehicle computing system (200), comprising:
- a circuit board (120) with conducting paths,
- computing components mounted to the circuit board (120) and including at least a central processing unit (102) and a main memory (103),
- an edge connector (101) provided at an edge of the circuit board (120) and adapted to connect the circuit board to an edge connector socket (201) of said mainboard (204), and
- a plurality of interfaces (105) provided by said edge connector (101) for interfacing the computing module (100),
wherein the vehicle computing module (100) is adapted to be operated in a vehicle as a main computing unit of said vehicle computing system (200) and to perform the processing of data for said vehicle computing system (200), the data being received by the vehicle computing module via said interfaces (105), **characterized in that**:
said interfaces comprise a debug and boot port interface (108) and
the vehicle computing module is configured to receive boot mechanisms from a controller (202) of the mainboard (204).

2. Vehicle computing module of claim 1, wherein said interfaces (105) are configured to be adapted by a controller (202) of the mainboard (204).

3. Vehicle computing module of claim 2, wherein said interfaces (105) are configured to be adapted by the controller (202) of the mainboard depending on the type of the central processing unit (102) of the vehicle computing module.

4. Vehicle computing module according to any one of the preceding claims, wherein said interfaces comprise at least one of a Peripheral Component Interconnect Express interface, a Universal Serial Bus interface, a Serial Advanced Technology Attachment interface, a Secure Digital Input Output interface, a Low-voltage differential signaling interface, a universal asynchronous receiver/transmitter interface and a power supply control interface.

5. Vehicle computing module according to any one of the preceding claims, wherein the debug and boot port interface (108) provided by the edge connector (101) is directly connected to a corresponding interface provided by said central processing unit (102).

6. Vehicle computing module according to any one of the preceding claims, wherein the debug and boot port interface (108) uses at least four pins of said edge connector.

7. Vehicle computing module according to any one of the preceding claims, wherein the debug and boot port interface (108) is configured to support different types of the central processing unit (102) without changing an assignment of pins of the edge connector (101).

8. Vehicle computing module according to any of the preceding claims, wherein the computing components further comprise a northbridge and a southbridge or a combined north/southbridge (104), a clock generator (107), and a voltage converter (106).

9. Vehicle computing system, comprising
- a mainboard (204) having interfaces (203) towards components of the vehicle and an edge connector socket (201) adapted to receive an edge connector (101), and
- a vehicle computing module (100) according to any of claims 1 to 8 and adapted to be connected to said mainboard (204) by means of said edge connector (101).

10. Vehicle computing system according to claim 9, wherein the vehicle computing system (200) is a vehicle-specific system adapted to the particular type of vehicle to which it is to be mounted, and wherein the vehicle computing module (100) is a standardized vehicle computing module adapted to be used with a plurality of different vehicle computing systems (200) adapted to different types of vehicles.

11. Vehicle computing system according to claim 9 or 10, wherein the mainboard (204) comprises a field-programmable gate array, an application-specific integrated circuit or a microcontroller for controlling the startup of and/or the communication with the vehicle computing module (100).

12. Vehicle computing system according to any of claims 9-11, wherein the edge connector socket (201) is formed so that the mainboard (204) and the circuit board (120) of the vehicle computing module (100) have a distance in a range between 2 and 9mm, preferably between 6 and 8 mm.

13. Vehicle computing system according to any of claims 9-12, wherein the vehicle computing system (200) is selected from a group comprising a vehicle infotainment system, a vehicle multimedia system, a vehicle navigation system, a vehicle control system, and an integrated vehicle computing system combining two or more of these systems.

14. Vehicle computing system according to any of claim 9-13, wherein the interfaces (203) of the mainboard towards the vehicle comprise at least one of a controller area network interface, a local interconnect network interface and a Media Oriented Systems Transport interface, the mainboard being configured to transport data received on one of these interfaces to the vehicle computing module (100) for processing.

15. Use of a vehicle computing module (100) according to any of claims 1-8 in a vehicle for performing processing functions for a computing system of said vehicle.

## Patentansprüche

1. Fahrzeugrechenmodul (100), das angepasst ist, um mit einem Mainboard (204) eines Fahrzeugrechensystems (200) verbunden zu werden, umfassend:
- eine Leiterplatte (120) mit Leiterbahnen,
- Rechenkomponenten, die an der Leiterplatte (120) angebracht sind und zumindest eine Zentraleinheit (102) und einen Hauptspeicher (103) beinhalten,
- einen Randstecker (101), der an einem Rand der Leiterplatte (120) bereitgestellt und angepasst ist, um die Leiterplatte mit einer Randsteckerbuchse (201) des Mainboards (204) zu verbinden, und
- eine Vielzahl von Schnittstellen (105), die durch den Randstecker (101) bereitgestellt sind, um das Rechenmodul (100) zu verbinden,
wobei das Fahrzeugrechenmodul (100) angepasst ist, um in einem Fahrzeug als eine Hauptrecheneinheit des Fahrzeugrechensystems (200) betrieben zu werden und um die Verarbeitung von Daten für das Fahrzeugrechensystem (200) durchzuführen, wobei die Daten von dem Fahrzeugrechenmodul über die Schnittstellen (105) empfangen werden,
**dadurch gekennzeichnet, dass**:
die Schnittstellen eine Debug- und Boot-Anschluss-Schnittstelle (108) umfassen und das Fahrzeugrechenmodul konfiguriert ist, um Boot-Mechanismen von einer Steuerung (202) des Mainboards (204) zu empfangen.

2. Fahrzeugrechenmodul nach Anspruch 1, wobei die Schnittstellen (105) konfiguriert sind, um durch eine Steuerung (202) des Mainboards (204) angepasst zu werden.

3. Fahrzeugrechenmodul nach Anspruch 2, wobei die Schnittstellen (105) konfiguriert sind, um durch die Steuerung (202) des Mainboards abhängig von der Art der Zentraleinheit (102) des Fahrzeugrechenmoduls angepasst zu werden.

4. Fahrzeugrechenmodul nach einem der vorhergehenden Ansprüche, wobei die Schnittstellen zumindest eine von einer Peripheral-Component-Interconnect-Express-Schnittstelle, einer Universal-Serial-Bus-Schnittstelle, einer Serial-Advanced-Technology-Attachment-Schnittstelle, einer Secure-Digital-Input-Output-Schnittstelle, einer Low-Voltage-Differential-Signaling-Schnittstelle, einer Universal-Asynchronous-Receiver/Transmitter-Schnittstelle und einer Stromversorgungssteuerungsschnittstelle umfassen.

5. Fahrzeugrechenmodul nach einem der vorhergehenden Ansprüche, wobei die Debug- und Boot-Anschluss-Schnittstelle (108), die durch den Randstecker (101) bereitgestellt ist, direkt mit einer entsprechenden Schnittstelle verbunden ist, die durch die Zentraleinheit (102) bereitgestellt ist.

6. Fahrzeugrechenmodul nach einem der vorhergehenden Ansprüche, wobei die Debug- und Boot-Anschluss-Schnittstelle (108) zumindest vier Stifte des Randsteckers verwendet.

7. Fahrzeugrechenmodul nach einem der vorhergehenden Ansprüche, wobei die Debug- und Boot-Anschluss-Schnittstelle (108) konfiguriert ist, um verschiedene Arten der Zentraleinheit (102) zu unterstützen, ohne eine Zuweisung von Stiften des Randsteckers (101) zu ändern.

8. Fahrzeugrechenmodul nach einem der vorhergehenden Ansprüche, wobei die Rechenkomponenten ferner eine Northbridge und eine Southbridge oder eine kombinierte North-/Southbridge (104), einen Taktgeber (107) und einen Spannungswandler (106) umfassen.

9. Fahrzeugrechensystem, umfassend
- ein Mainboard (204), das Schnittstellen (203) in Richtung von Komponenten des Fahrzeugs und eine Randsteckerbuchse (201) aufweist, die angepasst ist, um einen Randstecker (101) zu empfangen, und
- ein Fahrzeugrechenmodul (100) nach einem der Ansprüche 1 bis 8 und angepasst, um mittels des Randsteckers (101) mit dem Mainboard (204) verbunden zu werden.

10. Fahrzeugrechensystem nach Anspruch 9, wobei das Fahrzeugrechensystem (200) ein fahrzeugspezifisches System ist, das an die bestimmte Art von Fahrzeug, an dem es angebracht werden soll, angepasst ist, und wobei das Fahrzeugrechenmodul (100) ein standardisiertes Fahrzeugrechenmodul ist, das angepasst ist, um mit einer Vielzahl von verschiedenen Fahrzeugrechensystemen (200), die an verschiedene Arten von Fahrzeugen angepasst sind, verwendet zu werden.

11. Fahrzeugrechensystem nach Anspruch 9 oder 10, wobei das Mainboard (204) ein feldprogrammierbares Gate-Array, eine anwendungsspezifische integrierte Schaltung oder eine Mikrosteuerung umfasst, um das Starten von und/oder die Kommunikation mit dem Fahrzeugrechenmodul (100) zu steuern.

12. Fahrzeugrechensystem nach einem der Ansprüche 9-11, wobei die Randsteckerbuchse (201) derart geformt ist, dass das Mainboard (204) und die Leiterplatte (120) des Fahrzeugrechenmoduls (100) einen Abstand in einer Spanne zwischen 2 und 9 mm, vorzugsweise zwischen 6 und 8 mm aufweisen.

13. Fahrzeugrechensystem nach einem der Ansprüche 9-12, wobei das Fahrzeugrechensystem (200) aus einer Gruppe ausgewählt ist, umfassend ein Fahrzeug-Infotainment-System, ein Fahrzeug-Multimedia-System, ein Fahrzeugnavigationssystem, ein Fahrzeugsteuersystem und ein integriertes Fahrzeugrechensystem, das zwei oder mehrere dieser Systeme kombiniert.

14. Fahrzeugrechensystem nach einem der Ansprüche 9-13, wobei die Schnittstellen (203) des Mainboards in Richtung des Fahrzeugs zumindest eine von einer Controller-Area-Network-Schnittstelle, einer Lokal-Interconnect-Network-Schnittstelle und einer Media-Oriented-Systems-Transport-Schnittstelle umfassen, wobei das Mainboard konfiguriert ist, um Daten, die an einer dieser Schnittstellen empfangen werden, zur Verarbeitung zu dem Fahrzeugrechenmodul (100) zu transportieren.

15. Verwendung eines Fahrzeugrechenmoduls (100) nach einem der Ansprüche 1-8 in einem Fahrzeug zur Durchführung von Verarbeitungsfunktionen für ein Rechensystem des Fahrzeugs.

## Revendications

1. Module de calcul de véhicule (100) adapté pour être connecté à une carte mère (204) d'un système de calcul de véhicule (200), comprenant :
- une carte de circuit imprimé (120) avec des chemins de conduction,
- des composants de calcul montés sur la carte de circuit imprimé (120) et incluant au moins une unité centrale (102) et une mémoire principale (103),
- un connecteur latéral (101) prévu sur un bord de la carte de circuit imprimé (120) et adapté pour connecter la carte de circuit imprimé à une embase de connecteur latéral (201) de ladite carte mère (204), et
- une pluralité d'interfaces (105) fournies par ledit connecteur latéral (101) pour interfacer le module de calcul (100),
dans lequel le module de calcul de véhicule (100) est adapté pour être utilisé dans un véhicule en tant qu'unité de calcul principale dudit système de calcul de véhicule (200) et pour réaliser le traitement de données pour ledit système de calcul de véhicule (200), les données étant reçues par le module de calcul de véhicule via lesdites interfaces (105),
**caractérisé en ce que** :
lesdites interfaces comprennent une interface de port de débogage et d'amorçage (108) et le module de calcul de véhicule est configuré pour recevoir des mécanismes d'amorçage d'un contrôleur (202) de la carte mère (204).

2. Module de calcul de véhicule selon la revendication 1, dans lequel lesdites interfaces (105) sont configurées pour être adaptées par un contrôleur (202) de la carte principale (204).

3. Module de calcul de véhicule selon la revendication 2, dans lequel lesdites interfaces (105) sont configurées pour être adaptées par le contrôleur (202) de la carte mère en fonction du type d'unité centrale (102) du module de calcul de véhicule.

4. Module de calcul de véhicule selon l'une quelconque des revendications précédentes, dans lequel lesdites interfaces comprennent au moins l'une d'une interface d'Interconnexion de composants périphériques express, d'une interface de bus série universel, d'une interface de connexion par technologie avancée en série, d'une interface d'entrée et de sortie numériques sécurisées, d'une interface de signalisation différentielle basse tension, d'une interface de réception et d'émission asynchrone universelle et d'une interface de contrôle d'alimentation électrique.

5. Module de calcul de véhicule selon l'une quelconque des revendications précédentes, dans lequel l'interface de port de débogage et d'amorçage (108) fournie par le connecteur latéral (101) est directement connectée à une interface correspondante fournie par ladite unité centrale (102).

6. Module de calcul de véhicule selon l'une quelconque des revendications précédentes, dans lequel l'interface de port de débogage et d'amorçage (108) utilise au moins quatre broches dudit connecteur latéral.

7. Module de calcul de véhicule selon l'une quelconque des revendications précédentes, dans lequel l'interface de port de débogage et d'amorçage (108) est configurée pour supporter différents types d'unité centrale (102) sans modifier une affectation de broches du connecteur latéral (101).

8. Module de calcul de véhicule selon l'une quelconque des revendications précédentes, dans lequel les composants de calcul comprennent en outre un contrôleur de mémoire (northbridge) et un contrôleur d'entrée-sortie (southbridge) ou un circuit combiné north et southbridge (104), un générateur d'horloge (107), et un convertisseur de tension (106) .

9. Système de calcul de véhicule, comprenant
- une carte principale (204) ayant des interfaces (203) vers des composants du véhicule et une embase de connecteur latéral (201) adaptée pour recevoir un connecteur latéral (101), et
- un module de calcul de véhicule (100) selon l'une quelconque des revendications 1 à 8 et adapté pour être connecté à ladite carte principale (204) au moyen dudit connecteur latéral (101).

10. Système de calcul de véhicule selon la revendication 9, dans lequel le système de calcul de véhicule (200) est un système spécifique au véhicule adapté au type particulier de véhicule sur lequel il doit être monté, et dans lequel le module de calcul de véhicule (100) est un module de calcul de véhicule normalisé adapté pour être utilisé avec une pluralité de systèmes de calcul de véhicule (200) différents adaptés aux différents types de véhicules.

11. Système de calcul de véhicule selon la revendication 9 ou 10, dans lequel la carte principale (204) comprend une matrice prédiffusée programmable, un circuit intégré spécifique à l'application ou un microcontrôleur pour contrôler le démarrage du module de calcul de véhicule (100) et/ou la communication avec celui-ci.

12. Système de calcul de véhicule selon l'une quelconque des revendications 9 à 11, dans lequel l'embase de connecteur latéral (201) est formée de telle sorte que la carte principale (204) et la carte de circuit imprimé (120) du module de calcul de véhicule (100) ont une distance dans une plage comprise entre 2 et 9 mm, de préférence, entre 6 et 8 mm.

13. Système de calcul de véhicule selon l'une quelconque des revendications 9 à 12, dans lequel le système de calcul de véhicule (200) est choisi dans un groupe comprenant un système d'information-divertissement de véhicule, un système multimédia de véhicule, un système de navigation de véhicule, un système de contrôle de véhicule et un système de calcul de véhicule intégré combinant deux de ces systèmes ou plus.

14. Système de calcul de véhicule selon l'une quelconque des revendications 9 à 13, dans lequel les interfaces (203) de la carte principale vers le véhicule comprennent au moins l'une d'une interface de réseau de zone de contrôleur, une interface de réseau d'interconnexion local et une interface de transport de systèmes orientés milieu, la carte mère étant configurée pour transporter des données reçues sur l'une de ces interfaces vers le module de calcul de véhicule (100) pour traitement.

15. Utilisation d'un module de calcul de véhicule (100) selon l'une quelconque des revendications 1 à 8 dans un véhicule pour effectuer des fonctions de traitement pour un système de calcul dudit véhicule.
